# EUROPÄISCHE PATENTSCHRIFT

(11) **EP 1 306 953 B1**
(45) Veröffentlichungstag und Bekanntmachung des Hinweises auf die Patenterteilung: **08.04.2009**
(21) Anmeldenummer: 02023810.1
(22) Anmeldetag: 23.10.2002
(51) Int. Cl.: H02G 3/22, B60R 16/02

(54) **Durchführungsanordnung**
Leadthrough arrangement
Dispositif de traversée

(30) Priorität: 24.10.2001 DE 10152568
(43) Veröffentlichungstag der Anmeldung: 02.05.2003
(73) Patentinhaber: Delphi Technologies, Inc., Troy, MI 48007 (US)
(72) Erfinder: Wagner, Marcus A., 44869 Bochum (DE); Bramesfeld, Wulf, 42489 Wülfrath (DE); Daub, Klaus, 47259 Duisburg (DE)
(74) Vertreter: Denton, Michael John

(56) Entgegenhaltungen:
- US-A- 6 064 003
- PATENT ABSTRACTS OF JAPAN vol. 1996, no. 05, 31. Mai 1996 (1996-05-31) & JP 08 009538 A (FURUKAWA ELECTRIC CO LTD:THE), 12. Januar 1996 (1996-01-12)

## Beschreibung

Die Erfindung betrifft eine abgedichtete Durchführungsanordnung für eine elektrische Leitung mit flachem Querschnitt, insbesondere ein flexibles Flachkabel (FFC) oder eine flexible gedruckte Schaltung (FPC), und ein Verfahren zum Abdichten einer derartigen Durchführungsanordnung.

Eine Durchführungsanordnung gemäß dem Oberbegriff des Anspruchs 1 und ein Verfahren gemäß dem Oberbegriff des Anspruchs 11 sind in der JP-A-08009538 offenbart.

Grundsätzlich sind abgedichtete Kabeldurchführungen, insbesondere für elektrische Leitungen mit rundem Querschnitt oder Kabelstränge bekannt. Typischerweise werden abgedichtete Kabeldurchführungen dort eingesetzt, wo eine elektrische Leitung von einem trockenen Bereich durch die Öffnung in einer Trennwand in einen nassen Bereich zu führen ist und verhindert werden muss, dass Feuchtigkeit von dem nassen Bereich durch die Kabeldurchführung hindurch in den trockenen Bereich eindringt.

Ist beispielsweise eine in der Tür eines Kraftfahrzeugs befindliche elektrische Komponente, z.B. der Antrieb einer elektrischen Fensterhebereinrichtung, mit einer im Motorraum des Kraftfahrzeugs befindlichen Stromversorgung, z.B. einer Autobatterie, zu verbinden, so muss ein hierfür verwendetes Stromleitungskabel aus dem Inneren der Fahrzeugkarosserie durch das Karosserieblech hindurch nach außen und entsprechend von außen durch das Türblech in das Innere der Tür geführt werden. Dabei stellen sowohl das Innere der Fahrzeugtür als auch das Innere der Fahrzeugkarosserie sogenannte trockene Bereiche dar, die vor einem Eindringen von Feuchtigkeit aus dem außerhalb der Tür und der Karosserie liegenden Bereich geschützt werden sollen.

Bekannte abgedichtete Durchführungsanordnungen und Verfahren zum Abdichten derartiger Durchführungsanordnungen umfassen beispielsweise das Durchführen einer elektrischen Leitung durch eine in einer Trennwand befindliche Öffnung und ein anschließendes Ausgießen der Öffnung mit einem flüssigen Dichtmaterial, das, gegebenenfalls unter Einwirkung von Wärme, aushärtet. Unter Umständen geht das Dichtmaterial mit einem Isolationsmaterial der elektrischen Leitung eine Materialverbindung ein, die sich nachträglich nicht mehr lösen lässt, was sich im Falle späterer Reparaturen oder beim Recycling der verwendeten elektrischen Komponenten als ungünstig erweisen kann.

Der Erfindung liegt die Aufgabe zugrunde, eine abgedichtete Durchführungsanordnung für eine elektrische Leitung mit flachem Querschnitt zu schaffen, die von möglichst hoher Zuverlässigkeit ist und sich besonders einfach und insbesondere auch nach dem Verlegen der elektrischen Leitung herstellen lässt.

Zur Lösung der Aufgabe ist eine Durchführungsanordnung mit den Merkmalen des Anspruchs 1 vorgesehen.

Eine erfindungsgemäße Durchführungsanordnung weist einen Träger insbesondere zur Trennung eines Trockenbereiches von einem Nassbereich, beispielsweise ein Fahrzeugtürblech oder ein Fahrzeugkarosserieblech, in dem eine Öffnung vorgesehen ist, zumindest eine elektrische Leitung mit flachem Querschnitt, insbesondere ein flexibles Flachkabel (FFC) oder eine flexible gedruckte Schaltung (FPC), die derart durch die Öffnung geführt ist, dass sie auf beiden Trägerseiten jeweils mit einer Flachseite in einem an die Öffnung angrenzenden Auflagebereich an dem Träger anliegt, und eine Dichtung auf, die zumindest zwei auf gegenüberliegenden Trägerseiten angeordnete Abdeckungen aufweist, die auf beiden Trägerseiten jeweils die Öffnung und die Öffnung umgebende Randbereiche des Trägers abdichtend überdecken und in den Auflagebereichen jeweils abdichtend an der Leitung anliegen.

Die Erfindung erweist sich als besonders vorteilhaft für elektrische Leitungen mit flachem Querschnitt, für die einfache Abdichtlösungen im Bereich von Durchführungen nicht bekannt sind. Es wird in vorteilhafter Weise das Aufliegen der Flachseiten der Leitung auf Randbereichen des Trägers ausgenutzt, indem in diesen Auflagebereichen Abdeckungen an die Leitung angelegt werden. Für ein abdichtendes Anschmiegen der Abdeckungen an die Leitung wird dabei besonders ausgenutzt, dass die flache Leitung wenig aufträgt.

Die erfindungsgemäße Durchführungsanordnung kann insbesondere einen durch den Träger von einem Nassbereich getrennten Trockenbereich vor dem Eindringen von Feuchtigkeit aus dem Nassbereich schützen, indem Feuchtigkeit, die auf einer zum Nassbereich weisenden Trägerseite über einen Zwischenraum zwischen Leitung und Auflagebereich in die Öffnung gelangt, durch die auf der anderen Trägerseite anliegende Abdeckung in der Öffnung gehalten und an einem Eindringen in den Trockenbereich gehindert wird. Durch die erfindungsgemäße Verwendung von zwei auf gegenüberliegenden Trägerseiten angeordneten Abdeckungen wird folglich eine zuverlässige Dichtwirkung erreicht.

Des Weiteren ist die erfindungsgemäße Durchführungsanordnung auf besonders einfache Weise herstellbar. Benötigt werden lediglich zwei Abdeckungen, die derart an den gegenüberliegenden Seiten des Trägers angebracht werden, dass sie die Öffnung und die Öffnung umgebende Randbereiche des Trägers abdichtend überdecken und an der elektrischen Leitung abdichtend anliegen. Die Abdeckungen sind bevorzugt derart ausgebildet, dass sie sich in den kritischen Auflagebereichen an die elektrische Leitung derart anschmiegen, dass an keiner Stelle der Auflagebereiche ein Zwischenraum zwischen Träger und Abdeckung oder zwischen Leitung und Abdeckung vorhanden ist, durch den z.B. Feuchtigkeit oder Staub eindringen könnte. Die erfindungsgemäße Durchführungsanordnung eignet sich daher besonders gut für elektrische Leitungen mit flachem Querschnitt, da gerade bei diesen ein dichtendes Anliegen der Abdeckungen an der elektrischen Leitung bzw. dem Träger in einem Übergangsbereich zwischen Leitung und Träger auf einfache Weise gewährleistet werden kann.

Darüber hinaus lässt sich die Dichtung der erfindungsgemäßen Durchführungsanordnung auch nachträglich, d.h. nach erfolgter Verlegung der elektrischen Leitung installieren. So kann beispielsweise das elektrische System oder insbesondere ein ganzer Kabelstrang, wie z.B. ein FPC-Kabelbaum, eines Kraftfahrzeuges komplett verlegt und erst im Rahmen eines Endmontageschrittes die Dichtung nachträglich eingefügt werden, indem erfindungsgemäß die Abdeckungen auf beiden Seiten des jeweiligen Trägers, z.B. eines Türblechs, angebracht werden.

Durch Entfernen und Wiederanbringen der Abdeckungen lässt sich die Dichtung der erfindungsgemäßen Durchführungsanordnung auf einfache Weise erneuern. Ebenso lassen sich zu Recyclingzwecken die einzelnen Bestandteile der Durchführungsanordnung leicht voneinander trennen.

Vorteilhafte Ausführungsformen der Erfindung sind in den Unteransprüchen, der Beschreibung und der Zeichnung beschrieben.

So kann nach einer ersten vorteilhaften Ausführungsform der Erfindung die elektrische Leitung im Bereich der Öffnung einen stufenförmigen Verlauf aufweisen. Aufgrund dieser Ausbildung verläuft die elektrische Leitung im Fall eines zumindest im Bereich der Öffnung parallele Trägerseiten aufweisenden Trägers parallel versetzt durch die Öffnung hindurch, wobei sie mit ihrer einen Flachseite im einen Auflagebereich und mit ihrer anderen Flachseite im anderen, auf der gegenüberliegenden Trägerseite befindlichen Auflagebereich am Träger anliegt.

Durch diesen Verlauf der elektrischen Leitung wird sichergestellt, dass einem Auflagebereich der einen Trägerseite auf der anderen Trägerseite gerade kein Auflagebereich, sondern ein abgedichteter Randbereich gegenüberliegt, in welchem die Abdeckung direkt am Träger anliegt, so dass auf der einen Trägerseite zwischen Leitung und Auflagebereich in die Öffnung eingedrungene Feuchtigkeit stets durch eine auf der anderen Trägerseite direkt anliegende Abdeckung an einem Eindringen in einen Trockenbereich gehindert ist.

Des Weiteren wird aufgrund dieser Ausführungsform eine flache Bauweise der erfindungsgemäßen Durchführungsanordnung erreicht sowie eine übermäßige Krümmung der elektrischen Leitung vermieden.

Gemäß einer weiteren vorteilhaften Ausführungsform der erfindungsgemäßen Durchführungsanordnung umfassen die Abdeckungen ein flexibles Flächenmaterial und insbesondere ein Folien- oder Gewebematerial. Aufgrund seiner Flexibilität schmiegt sich das Abdeckmaterial in den Randbereichen besonders gut an die Oberfläche des Trägers und die elektrische Leitung an, so dass eine zuverlässig abdichtende Überdeckung der Öffnung und aller angrenzenden Randbereiche des Trägers auch im Bereich der elektrischen Leitung gewährleistet ist.

Bevorzugt sind die Abdeckungen aufgeklebt und insbesondere selbstklebend ausgebildet. Derartige Abdeckungen lassen sich besonders leicht und ohne zusätzliche Klebstoffe oder andere Hilfsmittel an dem Träger anbringen.

Besonders vorteilhaft ist es, wenn die Abdeckungen jeweils in Form eines Klebebands vorgesehen sind, wodurch sich die Dichtung der Durchführungsanordnung besonders einfach und kostengünstig realisieren lässt. Es lassen sich handelsübliche Klebebänder verwenden, d.h. ein Spezialmaterial ist für die Abdeckungen nicht erforderlich.

Nach einer weiteren Ausbildung der Erfindung ist ein von den Abdeckungen begrenzter Hohlraum zwischen den Abdeckungen zumindest teilweise durch ein die elektrische Leitung umgebendes Dichtmaterial ausgefüllt.

Dieses Dichtmaterial stellt eine Barriere für äußere Einflüsse dar, die nicht durch die Trägeröffnung hindurch treten sollen.

Besonders vorteilhaft ist es, wenn ein zum Aufkleben der Abdeckungen verwendeter Klebstoff in einer Stärke derart auf die Abdeckungen aufgetragen wird, dass er vorhandene Hohlräume ausfüllt und insbesondere ein Eindringen von Feuchtigkeit begünstigende Kapillareffekte an Übergangsstellen verhindert. In diesem Fall wirkt der Klebstoff gleichermaßen als Klebstoff und als Dichtmaterial, wodurch auf ein zusätzliches Dichtmaterial verzichtet werden kann.

Vorteilhafterweise ist das Dichtmaterial in einem Vormontagezustand bereits an zumindest einer der Abdeckungen angebracht. Dies erleichtert die Herstellung der Dichtung, da sich das Dichtmaterial und die Abdeckungen separat und damit unabhängig von dem Träger vorbereiten lassen.

Bevorzugt ist das Dichtmaterial verformbar. Dadurch kann sich das Dichtmaterial besonders gut den Konturen der elektrischen Leitung und der Öffnung anpassen, was die Dichtwirkung des Dichtmaterials weiter erhöht.

Vorzugsweise weist die Öffnung eine größere Breite auf als die Leitung.

Gemäß einer weiteren Variante der erfindungsgemäßen Durchführungsanordnung berühren die Abdeckungen einander in den seitlich der elektrischen Leitung gelegenen Bereichen der Öffnung. Insbesondere sind die Abdeckungen hier miteinander verbunden und dabei bevorzugt verklebt.

Bevorzugt steht die elektrische Leitung zumindest bereichsweise und insbesondere in einem Mittenbereich der Öffnung mit beiden Abdeckungen gleichzeitig in Berührung. Dabei ist die elektrische Leitung insbesondere mit den Abdeckungen verbunden, bevorzugt verklebt.

Auf diese Weise wird verhindert, dass aus einem auf der einen Trägerseite befindlichen Nassbereich Feuchtigkeit am Auflagebereich zwischen Leitung und Träger hindurch und z.B. an der Leitung entlang zum anderen Auflagebereich und dort auf der anderen Trägerseite zwischen der Leitung und dem Träger hindurch in einen Trockenbereich gelangen kann.

Aufgrund dieser Ausbildung ist außerdem die elektrische Leitung in der Öffnung besonders gut fixiert, wodurch Bewegungen der elektrischen Leitung bezüglich des Trägers verhindert werden können, die zu einer Ablösung der Abdeckung von der elektrischen Leitung bzw. dem Träger führen könnten.

Weiterer Gegenstand der Erfindung ist ein Verfahren zum Abdichten einer Durchführung für zumindest eine elektrische Leitung mit flachem Querschnitt, insbesondere ein flexibles Flachkabel (FFC) oder eine flexible gedruckte Schaltung (FPC), die durch eine Öffnung eines insbesondere zur Trennung eines Trockenbereiches von einem Nassbereich vorgesehenen Trägers, beispielsweise eines Fahrzeugtürblechs oder eines Fahrzeugkarosserieblechs, geführt wird, bei dem die Leitung derart durch die Öffnung geführt wird, dass sie auf beiden Trägerseiten jeweils mit einer Flachseite in einem an die Öffnung angrenzenden Auflagebereich an dem Träger anliegt, und die Öffnung beidseitig durch Abdeckungen abgedichtet wird, indem auf beiden Trägerseiten jeweils eine Abdeckung in einer die Öffnung und die Öffnung umgebende Randbereiche des Trägers abdichtenden Weise überdeckend an dem Träger fixiert wird, wobei die Abdeckungen in den Auflagebereichen jeweils abdichtend an die Leitung angelegt werden.

Mit diesem Verfahren lässt sich eine erfindungsgemäße Durchführungsanordnung auf besonders einfache Weise herstellen.

Gemäß einer Weiterbildung des Verfahrens wird ein durch die Abdeckungen begrenzter Hohlraum mit Dichtmaterial versehen.

In einer weiteren bevorzugten Ausführungsform des erfindungsgemäßen Verfahrens werden die Abdeckungen in seitlich der elektrischen Leitung gelegenen Bereichen der Öffnung miteinander in Verbindung gebracht und insbesondere miteinander verklebt.

Nachfolgend wird die vorliegende Erfindung rein beispielhaft anhand zweier vorteilhafter Ausführungsformen unter Bezugnahme auf die beigefügte Zeichnung beschrieben. Es zeigen:
- Fig. 1: eine erste Variante einer erfindungsgemäßen Durchführungsanordnung;
- Fig. 2: einen Querschnitt durch die Durchführungsanordnung in Fig. 1 entlang der Längsachse der elektrischen Leitung;
- Fig. 3: einen Querschnitt der Durchführungsanordnung in Fig. 1 quer zur Längsrichtung der elektrischen Leitung;
- Fig. 4: eine erfindungsgemäße Abdeckung mit vormontiertem Dichtmaterial;
- Fig. 5: eine zweite Variante einer erfindungsgemäßen Durchführungsanordnung;
- Fig. 6: eine Draufsicht auf die Durchführungsanordnung in Fig. 5;
- Fig. 7: einen Querschnitt durch die Durchführungsanordnung in Fig. 5 entlang der Längsachse der elektrischen Leitung; und
- Fig. 8: einen Querschnitt durch die Durchführungsanordnung in Fig. 5 quer zur Längsrichtung der elektrischen Leitung.

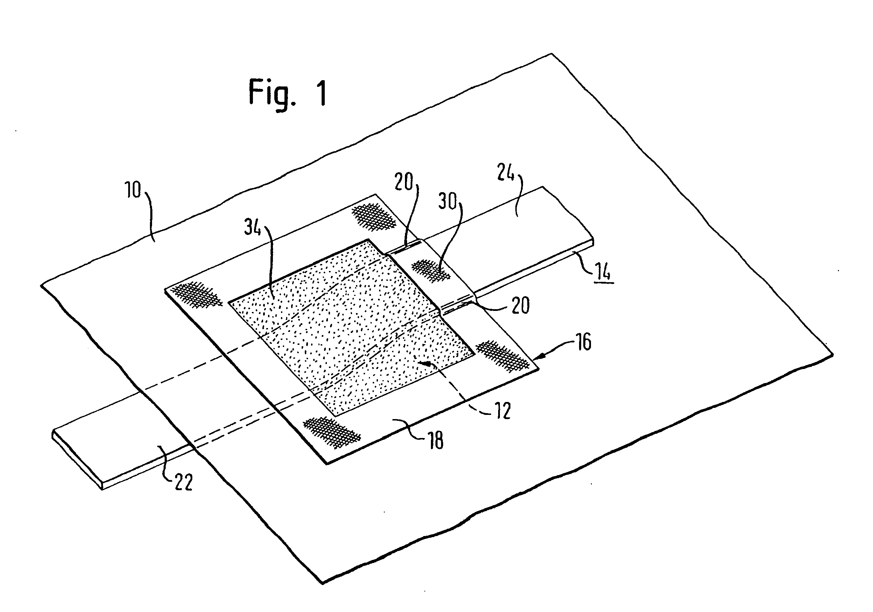

In Fig. 1 ist eine erste Variante einer erfindungsgemäßen Durchführungsanordnung gezeigt. Dargestellt ist ein Träger 10, beispielsweise ein Fahrzeugkarosserieblech oder ein Fahrzeugtürblech, der einen Trockenbereich von einem Nassbereich, beispielsweise das Innere eines Kraftfahrzeugs von der äußeren Umgebung, trennt. In dem Träger 10 ist eine in diesem Beispiel rechtwinklige Öffnung 12 vorgesehen, durch die eine elektrische Leitung 14 durchgeführt ist. Die elektrische Leitung 14 weist einen flachen Querschnitt auf. Es kann sich beispielsweise um ein flexibles Flachkabel (FFC) oder eine flexible gedruckte Schaltung (FPC) handeln.

Auf beiden Seiten des Trägers 10 ist jeweils eine Abdeckung 16 derart am Träger 10 angebracht, dass sie die Öffnung 12 und einen die Öffnung 12 umgebenden Randbereich 18 des Trägers 10 überdeckt. Die Abdeckungen 16 sind aus einem flexiblen Klebeband gebildet und werden derart über die Öffnung 12 und die Randbereiche 18 des Trägers 10 geklebt, dass sie abdichtend an der elektrischen Leitung 14 und am Träger 10 anliegen. Ein Unterlaufen der Abdeckungen 16 durch Feuchtigkeit aufgrund von Kapillarkräften wird zuverlässig dadurch verhindert, dass sich die Abdeckungen 16 insbesondere in Übergangsbereichen 20 zwischen Leitung 14 und Träger 10 abdichtend an die elektrische Leitung 14 und an den Träger 10 anschmiegen.

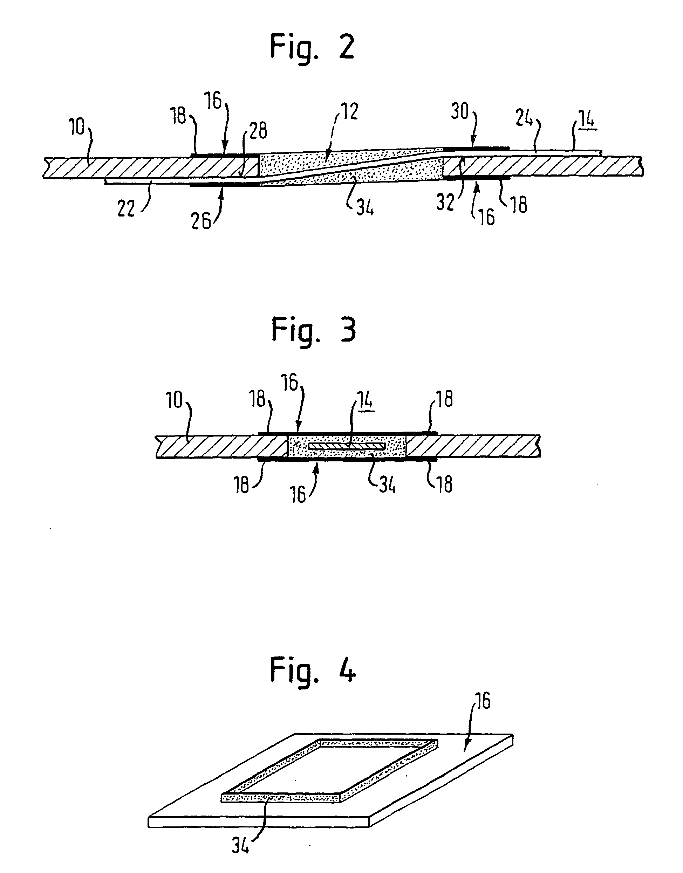

Wie insbesondere Fig. 2 zu entnehmen ist, wird die elektrische Leitung 14 stufenförmig durch die Öffnung 12 hindurchgeführt. Dabei verlaufen in diesem Beispiel die jeweils außerhalb der Öffnung 12 befindlichen Abschnitte 22, 24 zumindest bereichsweise parallel versetzt zueinander, wobei die elektrische Leitung 14 in einem ersten an die Öffnung 12 angrenzenden Auflagebereich 26 mit ihrer oberen Flachseite 28 und in einem zweiten an die Öffnung 12 angrenzenden Auflagebereich 30 mit ihrer unteren Flachseite 32 am Träger 10 anliegt.

Durch den stufenförmigen Verlauf der elektrischen Leitung 14 wird sichergestellt, dass einem Auflagebereich 26 der einen Trägerseite auf der anderen Trägerseite gerade kein Auflagebereich, sondern ein Randbereich 18 gegenüberliegt, in welchem die Abdeckung 16 direkt am Träger 10 anliegt, so dass auf der einen Trägerseite zwischen Leitung 14 und Träger 10 eingedrungene Feuchtigkeit stets durch eine auf der anderen Trägerseite direkt anliegende Abdeckung 16 an einem Durchqueren der Öffnung 12 und einem Eindringen in einen Trockenbereich gehindert ist.

Um eine zuverlässige Dichtwirkung der Durchführungsanordnung zu gewährleisten, ist ein von den Abdeckungen 16 begrenzter Hohlraum zwischen den Abdeckungen 16 durch ein an zumindest einem der Klebebänder 16 angebrachtes Dichtmaterial 34, z.B. Butyl, ausgefüllt, so dass zwischen den Auflagebereichen 26, 30 keine Verbindung besteht, über die Feuchtigkeit die Öffnung 12 durchqueren könnte. Wie in Fig. 3 gezeigt ist, umgibt das Dichtmaterial 34 die elektrische Leitung 14 vollständig.

Vorteilhafterweise werden die Abdeckungen bzw. die Klebebandstreifen 16 bereits in einem Vormontagezustand mit dem Dichtmaterial 34 versehen und anschließend in einer die Öffnung 12 und die Randbereiche 18 überdeckenden Weise auf den Träger 10 aufgeklebt.

Alternativ können die Abdeckungen 16 auch aus einem Zwei- oder Mehrkomponenten-Spritzgussmaterial hergestellt sein, das derart vorgeformt ist, dass es sich auf der jeweiligen Trägerseite abdichtend an die elektrische Leitung 14 und an die Oberfläche des Trägers 10 anschmiegt. Auch derartige Spritzgussteile können, bevor sie auf den Träger 10 geklebt werden, mit einem zusätzlichen Dichtmaterial 34 und/oder einem dick aufgetragenen Klebstoff versehen werden, das einen zwischen den Spritzgussteilen vorhandenen Hohlraum zumindest teilweise ausfüllt und dabei die elektrische Leitung 14 abdichtend umgibt.

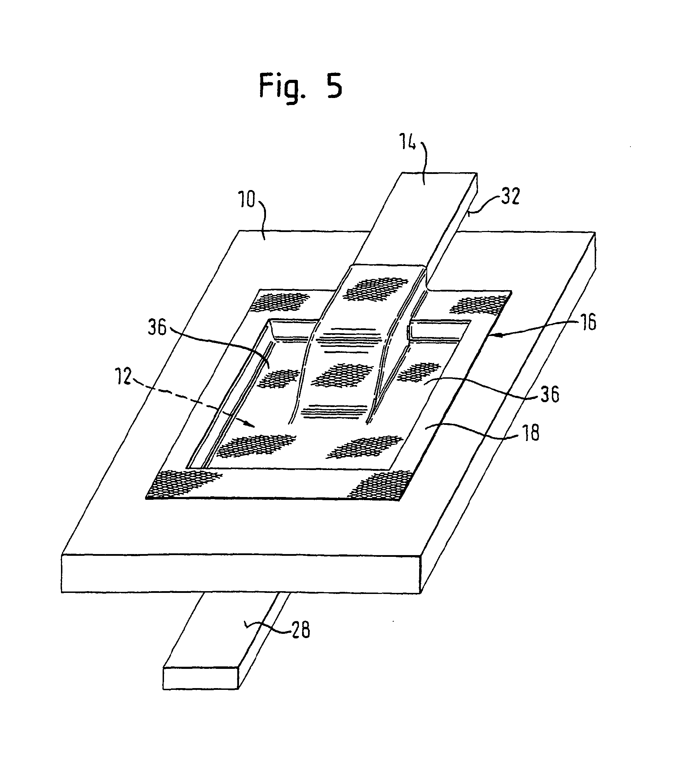

Fig. 5 zeigt eine zweite Variante der erfindungsgemäßen Durchführungsanordnung. Gleiche Teile sind dabei mit gleichen Bezugszeichen versehen. Entsprechend der ersten Variante ist ein Träger 10, beispielsweise ein Fahrzeugkarosserie- oder ein Fahrzeugtürblech, mit einer rechtwinkligen Öffnung 12 dargestellt, durch die eine elektrische Leitung 14 mit flachem Querschnitt, beispielsweise ein flexibles Flachkabel (FFC) oder eine flexible gedruckte Schaltung (FPC), stufenförmig hindurchgeführt ist, wobei eine obere Flachseite 28 der elektrischen Leitung 14 in einem ersten Auflagebereich 26 und eine untere Flachseite 32 der elektrischen Leitung 14 in einem zweiten Auflagebereich 30 am Träger 10 anliegt.

Auch bei dieser Variante der erfindungsgemäßen Durchführungsanordnung sind von beiden Seiten des Trägers 10 die Öffnung 12 und an die Öffnung 12 angrenzende Randbereiche 18 des Trägers 10 durch Abdeckungen 16 überdeckt, die auch hier durch auf den Träger 10 geklebte Klebebänder gebildet sind.

In diesem Beispiel sind die Klebebänder derart in die Öffnung 12 hineingedrückt, dass sie sich in seitlich neben der elektrischen Leitung 14 gelegenen Bereichen 36 berühren und miteinander verklebt sind.

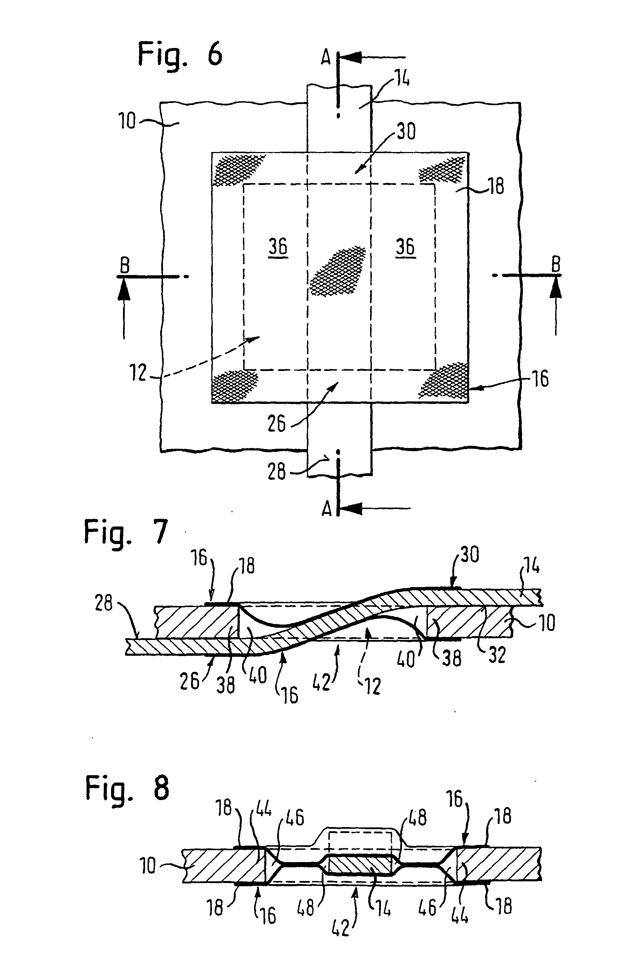

Fig. 6 ist die Lage der Schnittlinien A-A und B-B der in Fig. 7 und Fig. 8 gezeigten Schnittansichten zu entnehmen.

Fig. 7 zeigt den Schnitt A-A in Längsrichtung der elektrischen Leitung 14. Dargestellt ist, wie in den Bereichen der Öffnung 12, in denen die elektrische Leitung 14 aus der Öffnung 12 heraustritt, jeweils eine der Abdeckungen 16 an der elektrischen Leitung 14 anliegt, während die jeweils andere Abdeckung 16 im Randbereich 18 des Trägers 10 anliegt und in die Öffnung 12 hinein und in Richtung der Leitung 14 gedrückt ist.

Da der die Öffnung 12 begrenzende Trägerbereich 38 rechtwinklig ausgebildet ist, der Verlauf der elektrischen Leitung 14 und der Abdeckungen 16 dagegen gekrümmt ist, entstehen durch die elektrische Leitung 14, den Trägerbereich 38 und die Abdeckung 16 begrenzte Hohlräume 40, deren Größe insbesondere von der Flexibilität, Dehnbarkeit und/oder Schmiegefähigkeit der Abdeckungen 16 sowie ggf. von der Stärke eines aufgetragenen Klebstoffs bzw. eines ggf. zusätzlich vorhandenen Dichtmaterials abhängt.

In einem Mittenbereich 42 der Öffnung 12 sind beide Abdeckungen 16 mit der elektrischen Leitung 14 verklebt.

Feuchtigkeit könnte zwar z.B. von der einen Trägerseite aus am Auflagebereich 30 zwischen Leitung 14 und Träger 10 hindurch in den Hohlraum 40 gelangen. Durch das Verkleben der Leitung 14 mit den Abdeckungen 16 und durch das Verkleben der beiden Abdeckungen 16 miteinander wird aber verhindert, dass die Feuchtigkeit den Hohlraum 40 verlassen und z.B. an der Leitung 14 entlang zum anderen Auflagebereich 26 und dort zwischen der Leitung 14 und dem Träger 10 hindurch auf die andere Trägerseite gelangen kann.

Fig. 8 zeigt den Schnitt B-B quer zur Längsachse der elektrischen Leitung 14. Die Klebebänder 16 sind in den Randbereichen 18 mit dem Träger 10 verklebt, in die Öffnung hineingedrückt und in den seitlich neben der elektrischen Leitung 14 gelegenen Bereichen 36 miteinander verklebt. Im Mittenbereich 42 der Öffnung 12 sind beide Abdeckungen 16 mit den jeweiligen Flachseiten 28, 32 der elektrischen Leitung 14 verklebt.

Durch das Verkleben der elektrischen Leitung 14 mit den Abdeckungen 16 ist die elektrische Leitung 14 außerdem in ihrer Lage bezüglich des Trägers 10 fixiert. Auf diese Weise wird eine Bewegung der elektrischen Leitung 14 relativ zum Träger 10 praktisch ausgeschlossen.

Wegen der rechtwinkligen Ausbildung der parallel zur elektrischen Leitung 14 verlaufenden und die Öffnung 12 begrenzenden Trägerbereiche 44 sind auch hier durch die Abdeckungen 16 und den Trägerbereich 44 begrenzte Hohlräume 46 vorhanden. Entsprechend liegen im Mittenbereich 42 der Öffnung 12 auch an den Längskanten der elektrischen Leitung 14 durch die Abdeckungen 16 und die elektrische Leitung 14 begrenzte Hohlräume 48 vor.

Wie Fig. 8 zu entnehmen ist, kann in einen der Hohlräume 46 eingedrungene Feuchtigkeit wegen der im seitlichen Bereich 36 (vgl. Fig. 6) miteinander verklebten Abdeckungen 16 nicht in den entsprechenden Hohlraum 48, d.h. bis an die elektrische Leitung 14, gelangen, wodurch ein Hindurchtreten von Feuchtigkeit durch die Öffnung 12 sicher verhindert wird. Sofern Feuchtigkeit überhaupt in einen der Hohlräume 46 eintritt, ist sie in diesem gefangen. Entsprechend verhindert das Verkleben der Abdeckungen 16 mit der Leitung 14 (vgl. Fig. 7) das Hindurchtreten von eventuell in einen der Hohlräume 40 eingedrungener Feuchtigkeit auf die jeweils andere Seite des Trägers 10. Auf diese Weise wird eine besonders zuverlässige Dichtwirkung der Dichtungsanordnung sichergestellt.

Um eine Ansammlung möglicherweise in die Hohlräume 40, 46, 48 eingedrungener Feuchtigkeit zu begrenzen, wird durch möglichst eng an den die Öffnung 12 begrenzenden Trägerbereichen 38, 44 und an der Leitung 14 anliegende Abdeckungen 16 eine Minimierung der Hohlräume 40, 46 angestrebt, wobei z.B. durch dick aufgetragenen Klebstoff und/oder zusätzliches Dichtmaterial verbliebene Rest-Hohlräume praktisch vollständig ausgefüllt werden können.

Erfindungsgemäß wird dort, wo die Abdeckungen 16 direkt mit dem Träger 10 und der Leitung 14 verbunden und insbesondere verklebt sind, ein Eindringen von Feuchtigkeit sicher verhindert, wobei Kapillarwirkungen z.B. durch dick aufgetragenen Klebstoff unterbunden werden können. Eventuell an den Auflagebereichen 26, 30 zwischen Leitung 14 und Träger 10 hindurch eindringende Feuchtigkeit wird durch die innigen Verbindungen der Abdeckungen 16 mit der Leitung 14 einerseits und der Abdeckungen 16 miteinander andererseits daran gehindert, die jeweils andere Trägerseite zu erreichen.

Die Abdeckungen 16 sorgen somit für eine Abdichtung der Auflagebereiche 26, 30 gegenüber der jeweils anderen Trägerseite, d.h. ggf. an den Auflagebereichen 26, 30 zwischen Leitung 14 und Träger 10 hindurch eindringende Feuchtigkeit kann die Öffnung 12 nicht durchqueren.

### Bezugszeichenliste

- 10: Träger
- 12: Öffnung
- 14: elektrische Leitung
- 16: Abdeckung
- 18: Randbereich
- 20: Übergangsbereich
- 22: Leitungsabschnitt
- 24: Leitungsabschnitt
- 26: Auflagebereich
- 28: obere Flachseite
- 30: Auflagebereich
- 32: untere Flachseite
- 34: Dichtmaterial
- 36: seitlicher Bereich
- 38: Trägerbereich
- 40: Hohlraum
- 42: Mittenbereich
- 44: Trägerbereich
- 46: Hohlraum
- 48: Hohlraum

## Patentansprüche

1. Durchführungsanordnung mit
einem Träger (10) insbesondere zur Trennung eines Trockenbereiches von einem Nassbereich, beispielsweise einem Fahrzeugtürblech oder einem Fahrzeugkarosserieblech, in dem eine Öffnung (12) vorgesehen ist,
zumindest einer elektrischen Leitung (14) mit flachem Querschnitt, insbesondere einem flexiblen Flachkabel (FFC) oder einer flexiblen gedruckten Schaltung (FPC), und
einer Dichtung mit zumindest zwei auf gegenüber liegenden Trägerseiten angeordneten Abdeckungen (16), die auf beiden Trägerseiten jeweils die Öffnung (12) und die Öffnung (12) umgebende Randbereiche (18) des Trägers (10) abdichtend überdecken,
**dadurch gekennzeichnet, dass**
die elektrische Leitung (14) derart durch die Öffnung (12) geführt ist, dass sie auf beiden Trägerseiten jeweils mit einer Flachseite (28, 32) in einem an die Öffnung (12) angrenzenden Auflagebereich (26, 30) an dem Träger (10) anliegt, und
die Abdeckungen (16) der Dichtung in den Auflagebereichen (26, 30) jeweils abdichtend an der Leitung (14) anliegen.

2. Durchführungsanordnung nach Anspruch 1,
**dadurch gekennzeichnet,**
**dass** die elektrische Leitung (14) im Bereich der Öffnung (12) einen stufenförmigen Verlauf aufweist.

3. Durchführungsanordnung nach Anspruch 1 oder 2,
**dadurch gekennzeichnet,**
**dass** die Abdeckungen (16) ein flexibles Flächenmaterial und insbesondere ein Folien- oder Gewebematerial aufweisen.

4. Durchführungsanordnung nach einem der vorherigen Ansprüche,
**dadurch gekennzeichnet,**
**dass** die Abdeckungen (16) aufgeklebt und insbesondere selbstklebend ausgebildet sind.

5. Durchführungsanordnung nach einem der vorherigen Ansprüche,
**dadurch gekennzeichnet,**
**dass** die Abdeckungen (16) jeweils in Form eines Klebebands vorgesehen sind.

6. Durchführungsanordnung nach einem der vorherigen Ansprüche,
**dadurch gekennzeichnet,**
**dass** ein von den Abdeckungen (16) begrenzter Hohlraum zwischen den Abdeckungen (16) zumindest teilweise durch ein die elektrische Leitung (14) umgebendes Dichtmaterial (34) ausgefüllt ist.

7. Durchführungsanordnung nach Anspruch 6,
**dadurch gekennzeichnet,**
**dass** das Dichtmaterial (34) in einem Vormontagezustand bereits an zumindest einer der Abdeckungen (16) angebracht ist.

8. Durchführungsanordnung nach Anspruch 6 oder 7,
**dadurch gekennzeichnet,**
**dass** das Dichtmaterial (34) verformbar ist.

9. Durchführungsanordnung nach einem der vorherigen Ansprüche,
**dadurch gekennzeichnet,**
**dass** die Abdeckungen (16) in den seitlich der elektrischen Leitung (14) gelegenen Bereichen (36) der Öffnung (12) einander berühren und insbesondere miteinander verbunden, bevorzugt verklebt sind.

10. Durchführungsanordnung nach einem der vorherigen Ansprüche,
**dadurch gekennzeichnet,**
**dass** die elektrische Leitung (14) zumindest bereichsweise und insbesondere in einem Mittenbereich (42) der Öffnung (12) mit beiden Abdeckungen (16) gleichzeitig in Berührung steht und insbesondere verbunden, bevorzugt verklebt ist.

11. Verfahren zum Abdichten einer Durchführung für zumindest eine elektrische Leitung (14) mit flachem Querschnitt, insbesondere ein flexibles Flachkabel (FFC) oder eine flexible gedruckte Schaltung (FPC), die durch eine Öffnung (12) eines insbesondere zur Trennung eines Trockenbereiches von einem Nassbereich vorgesehenen Trägers (10), beispielsweise eines Fahrzeugtürblechs oder eines Fahrzeugkarosserieblechs, geführt wird, wobei die Öffnung (12) beidseitig durch Abdeckungen (16) abgedichtet wird, indem auf beiden Trägerseiten jeweils eine Abdeckung (16) die Öffnung (12) und die Öffnung (12) umgebende Randbereiche (18) des Trägers (10) abdichtend überdeckend an dem Träger (10) fixiert wird,
**dadurch gekennzeichnet, dass**
die Leitung (14) derart durch die Öffnung (12) geführt wird, dass sie auf beiden Trägerseiten jeweils mit einer Flachseite (28, 32) in einem an die Öffnung (12) angrenzenden Auflagebereich (26, 30) an dem Träger (10) anliegt, und
die Abdeckungen (16) in den Auflagebereichen (26, 30) jeweils abdichtend an die Leitung (14) angelegt werden.

12. Verfahren nach Anspruch 11,
**dadurch gekennzeichnet,**
**dass** ein durch die Abdeckungen (16) begrenzter Hohlraum mit Dichtmaterial (34) versehen wird.

13. Verfahren nach Anspruch 11 oder 12,
**dadurch gekennzeichnet,**
**dass** die Abdeckungen (16) in seitlich der elektrischen Leitung (14) gelegenen Bereichen (36) der Öffnung (12) miteinander in Verbindung gebracht und insbesondere miteinander verklebt werden.

14. Verfahren nach einem der Ansprüche 11 bis 13,
**dadurch gekennzeichnet,**
**dass** eine Durchführungsanordnung nach einem der Ansprüche 1 bis 10 verwendet wird.

## Claims

1. Leadthrough arrangement having
a carrier (10), in particular for separating a dry area and a wet area, for example a vehicle door sheet metal or a vehicle body sheet metal, provided with an opening (12),
at least one electric cable (14) with flat profile, in particular a flexible flat cable (FFC) or a flexible printed circuit (FPC), and
a seal having at least two coverings (16), arranged on opposite carrier sides, respectively covering and sealing the opening (12) and areas of the carrier (10) around (18) the opening (12) on both carrier sides,
**characterized in that**
the electric cable (14) is passed through the opening (12) such that on both carrier sides, respectively, it abuts with a flat side (28, 32) on a bearing area (26, 30), adjacent to the opening (12), on the carrier (10), and
the coverings (16) of the seal sealingly abut the cable (14) in the bearing areas (26, 30), respectively.

2. Leadthrough arrangement according to claim 1,
**characterized in that**
the electric cable (14) comprises a stepped course in the area of the opening (12).

3. Leadthrough arrangement according to claim 1 or 2,
**characterized in that**
the coverings (16) comprise a flexible sheet material and in particular a foil or fabric material.

4. Leadthrough arrangement according to one of the previous claims,
**characterized in that**
the coverings (16) are glued and in particular formed self-adhesive.

5. Leadthrough arrangement according to one of the previous claims,
**characterized in that**
the coverings (16) are provided in the form of an adhesive tape, respectively.

6. Leadthrough arrangement according to one of the previous claims,
**characterized in that**
a cavity between the coverings (16), limited by the coverings (16), is filled at least in part by a sealing material (34), encompassing the electric cable (14).

7. Leadthrough arrangement according to claim 6,
**characterized in that**
the sealing material (34) is already mounted on at least one of the coverings (16) in a pre-assembly condition.

8. Leadthrough arrangement according to claim 6 or 7,
**characterized in that**
the sealing material (34) is deformable.

9. Leadthrough arrangement according to one of the previous claims,
**characterized in that**
the coverings (16) in the areas (36) on the side of the electric cable (14) of the opening (12) are in contact with each other and in particular are connected with each other, preferably glued together.

10. Leadthrough arrangement according to one of the previous claims,
**characterized in that**
the electric cable (14) at least in part and in particular in a central region (42) of the opening (12) is in contact with both coverings (16) simultaneously and in particular connected, preferably glued.

11. Method of sealing a leadthrough for at least one electric cable (14) with flat profile, in particular a flexible flat cable (FFC) or a flexible printed circuit (FPC), passing through an opening (12) of a carrier (10), provided in particular for separating a dry area and a wet area, for example a vehicle door sheet metal or a vehicle body sheet metal, wherein the opening (12) is sealed on both sides by coverings (16), in that one covering (16) is fixed on the carrier (10) sealingly covering the opening (12) and areas of the carrier (10) around (18) the opening (12), on both carrier sides respectively,
**characterized in that**
the electric cable (14) is passed through the opening (12) such that it abuts with a flat side (28, 32) on a bearing area (26, 30), adjacent to the opening (12), on the carrier (10) on both carrier sides respectively, and
the coverings (16) sealingly abut the cable (14) in the bearing areas (26, 30), respectively.

12. Method according to claim 11,
**characterized in that**
a cavity, limited by the coverings (16), is provided with sealing material (34).

13. Method according to claim 11 or 12,
**characterized in that**
the coverings (16) are connected and in particular glued in areas (36) of the opening (12) on the side of the electric cable (14).

14. Method according to one of the claims 11 to 13,
**characterized in that**
a leadthrough arrangement according to one of the claims 1 to 10 is used.

## Revendications

1. Dispositif de traversée, comprenant :
un support (10), en particulier pour la séparation d'une zone sèche vis-à-vis d'une zone humide, par exemple une tôle de portière ou une tôle de carrosserie de véhicule, dans lequel/laquelle est prévue une ouverture (12),
au moins une ligne électrique (14) à section transversale aplatie, en particulier un câble plat souple ou un circuit imprimé flexible, et
un joint avec au moins deux couvertures (16) agencées sur des côtés mutuellement opposés du support, lesdites couvertures recouvrant sur les deux côtés du support de manière étanche l'ouverture respective (12) ainsi que les zones de bordure (18) du support (10) qui entourent l'ouverture (12),
**caractérisé en ce que**
la ligne électrique (14) est passée à travers l'ouverture (12) de telle manière qu'elle s'applique contre le support sur les deux côtés du support respectivement avec un côté plat (28, 32) dans une zone d'appui (26, 30) adjacente à l'ouverture (12), et
les couvertures (16) du joint s'appliquent respectivement de façon étanche contre la ligne (14) dans les zones d'appui (26, 30).

2. Dispositif de traversée selon la revendication 1,
**caractérisé en ce que** la ligne électrique (14) présente un tracé en gradins dans la zone de l'ouverture (12).

3. Dispositif de traversée selon la revendication 1 ou 2,
**caractérisé en ce que** les couvertures (16) comprennent un matériau surfacique flexible et en particulier à un matériau en film ou en tissu.

4. Dispositif de traversée selon l'une des revendications précédentes,
**caractérisé en ce que** les couvertures (16) sont collées et en particulier réalisées de façon autocollante.

5. Dispositif de traversée selon l'une des revendications précédentes,
**caractérisé en ce que** les couvertures (16) sont prévues respectivement sous la forme d'une bande à coller.

6. Dispositif de traversée selon l'une des revendications précédentes,
**caractérisé en ce qu'**une cavité délimitée par les couvertures (16) entre les couvertures (16) est remplie au moins partiellement par un matériau d'étanchement (34) qui entoure la ligne électrique (14).

7. Dispositif de traversée selon la revendication 6,
**caractérisé en ce que** le matériau d'étanchement (34) est appliqué dans une situation préalable au montage, déjà sur l'une au moins des couvertures (16).

8. Dispositif de traversée selon la revendication 6 ou 7,
**caractérisé en ce que** le matériau d'étanchement (34) est déformable.

9. Dispositif de traversée selon l'une des revendications précédentes,
**caractérisé en ce que** les couvertures (16) se touchent mutuellement et sont en particulier reliées l'une à l'autre et de préférence collées dans les zones (36) de l'ouverture (12) situées latéralement par rapport à la ligne électrique (14).

10. Dispositif de traversée selon l'une des revendications précédentes,
**caractérisé en ce que** la ligne électrique (14) est en contact simultané, et en particulier reliée et de préférence collée, avec les deux couvertures (16), au moins localement et en particulier dans une zone médiane (42) de l'ouverture (12).

11. Procédé pour étancher une traversée pour au moins une ligne électrique (14) à section transversale aplatie, en particulier un câble plat souple ou un circuit imprimé flexible, qui est passée à travers une ouverture (12) d'un support (10), par exemple une tôle de portière ou une tôle de carrosserie d'un véhicule, en particulier pour séparer une zone sèche vis-à-vis d'une zone humide, dans lequel l'ouverture (12) est étanchée des deux côtés par des couvertures (16) en fixant sur le support et les deux côtés du support une couverture (16) qui recouvre de manière étanche l'ouverture (12) et les zones de bordure (18) du support (10) qui entourent l'ouverture (12),
**caractérisé en ce que**
la ligne (14) est passée à travers l'ouverture (12) de telle manière qu'elle s'applique contre le support sur les deux côtés du support respectivement avec un côté plat (28, 32) dans une zone d'appui (26, 30) adjacente à l'ouverture (12), et
les couvertures (16) du joint s'appliquent respectivement de façon étanche contre la ligne (14) dans les zones d'appui (26, 30).

12. Procédé selon la revendication 11,
**caractérisé en ce qu'**une cavité délimitée par les couvertures (16) est remplie d'un matériau d'étanchement (34).

13. Procédé selon la revendication 11 ou 12,
**caractérisé en ce que** les couvertures (16) sont amenées en liaison l'une avec l'autre et en particulier collées l'une à l'autre dans des zones (36) de l'ouverture (12) situées latéralement par rapport à la ligne électrique (14).

14. Procédé selon l'une des revendications 11 à 13,
**caractérisé en ce que** l'on utilise un dispositif de traversée selon l'une des revendications 1 à 10.
